(19) Europäisches Patentamt / European Patent Office / Office européen des brevets

(11) **EP 4 484 875 A1**

(12) **EUROPEAN PATENT APPLICATION**
published in accordance with Art. 153(4) EPC

(43) Date of publication:
01.01.2025 Bulletin 2025/01

(21) Application number: 23823488.4

(22) Date of filing: 30.03.2023

(51) International Patent Classification (IPC):
F28D 15/02 (2006.01)      F25B 1/00 (2006.01)
F25B 5/04 (2006.01)       G03F 7/20 (2006.01)
H05K 7/20 (2006.01)

(52) Cooperative Patent Classification (CPC):
F25B 1/00; F25B 5/04; F28D 15/02; G03F 7/20;
H05K 7/20

(86) International application number:
PCT/JP2023/013209

(87) International publication number:
WO 2023/243184 (21.12.2023 Gazette 2023/51)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 13.06.2022 JP 2022095225

(71) Applicant: CANON KABUSHIKI KAISHA
Tokyo 146-8501 (JP)

(72) Inventor: NOMOTO, Makoto
Tokyo 146-8501 (JP)

(74) Representative: WESER & Kollegen
Patentanwälte PartmbB
Radeckestraße 43
81245 München (DE)

(54) **COOLING DEVICE, SEMICONDUCTOR MANUFACTURING DEVICE, AND SEMICONDUCTOR MANUFACTURING METHOD**

(57) There is provided that a cooling device for cooling a cooling target, characterized by including a circulation system configured to circulate a refrigerant for cooling the cooling target, wherein a container including a region where heat is exchanged between the refrigerant and at least a part of the cooling target is provided in the circulation system, the refrigerant is a mixed refrigerant obtained by mixing a first refrigerant of a first boiling point and a second refrigerant of a second boiling point higher than the first boiling point, the circulation system circulates the mixed refrigerant so that the mixed refrigerant enters the container at a predetermined temperature, and the first refrigerant has a vapor pressure higher than a pressure resistance of the container at the predetermined temperature.

**FIG. 1**

**Description**

TECHNICAL FIELD

The present invention relates to a cooling device, a semiconductor manufacturing apparatus and a semiconductor manufacturing method.

BACKGROUND ART

A semiconductor manufacturing apparatus such as a pattern forming apparatus such as an exposure apparatus, an imprint apparatus, or an electron beam lithography apparatus or a plasma processing apparatus such as a CVD apparatus, an etching apparatus, or a sputtering apparatus includes a driving mechanism or a heat generating portion such as a member that is heated by plasma. To cool the heat generating portion, the semiconductor manufacturing apparatus includes a cooling device. The cooling device cools the heat generating portion by taking heat from the heat generating portion and exhausting the heat outside the apparatus.

PTL 1 discloses a cooling system including an evaporator that extracts heat from a component, a condenser, a pump, an accumulator, a heat exchanger, and a temperature sensor. In the cooling system, a circulation path is constituted to return a fluid refrigerant from the pump via the evaporator and the condenser to the pump, and the accumulator communicates the fluid to the circulation path. The heat exchanger transfers heat from the fluid refrigerant in the accumulator and transfers heat to the fluid refrigerant in the accumulator. At this time, the amount of transferred heat is controlled based on an output from the temperature sensor.

CITATION LIST

PATENT LITERATURE

PTL 1: Japanese Patent No. 5313384

SUMMARY OF INVENTION

TECHNICAL PROBLEM

In general, a cooling system that circulates a liquid refrigerant by a pump often adopts a refrigerant (for example, HFO-1336mzz(E), Novec7000, or HFO-1233zd(Z)) with an atmospheric boiling point equal to or higher than room temperature, which does not require a liquefying means. When it is desirable to set a boiling temperature lower than the atmospheric boiling point using the refrigerant, a vapor pressure is lower than the atmospheric pressure.

Considering, as a cooling target of the cooling system, a linear motor having a jacket structure in which a coil is arranged in a closed container and is cooled by filling the internal space with a fluid refrigerant, the boiled vaporized refrigerant flows through an upper part of the internal space of the jacket due to a density difference. As heat generation of the coil is larger, the amount of the vaporized refrigerant increases, and the pressure is low. Thus, the vaporized refrigerant occupies the internal space of the jacket, thereby causing a state in which the upper portion of the coil as a heat generating portion is covered with the vaporized refrigerant and cannot be ebullient-cooled, that is, dryout. If dryout occurs, the temperature of the coil suddenly rises, and the coil is burned out.

To cope with this, it is considered to supply a sufficient amount (flow rate) of a refrigerant to ebullient-cool the coil that generates heat in the internal space of the jacket, but if the internal pressure is low, the vaporized refrigerant expands to occupy the upper part of the internal space of the jacket, thereby making it impossible to prevent dryout. Note that by further increasing the flow rate of the refrigerant and washing away the vapored refrigerant, it is possible to prevent dryout. However, in this case, since this is equivalent to convection cooling, it is impossible to obtain the advantage of ebullient cooling that a large amount of heat can be recovered at a low flow rate, thereby causing a pressure resistance problem arising from an increase in the flow rate of the refrigerant, an increase in size of the apparatus, and an increase in energy consumption.

The present invention provides a cooling device advantageous in cooling a cooling target.

SOLUTION TO PROBLEM

A cooling device as one aspect of the present invention is that a cooling device for cooling a cooling target, characterized by including a circulation system configured to circulate a refrigerant for cooling the cooling target, wherein a container including a region where heat is exchanged between the refrigerant and at least a part of the cooling target is provided in the circulation system, the refrigerant is a mixed refrigerant obtained by mixing a first refrigerant of a first boiling point and a second refrigerant of a second boiling point higher than the first boiling point, the circulation system circulates the mixed refrigerant so that the mixed refrigerant enters the container at a predetermined temperature, and the first refrigerant has a vapor pressure higher than a pressure resistance of the container at the predetermined temperature.

Further aspects of the present invention will become apparent from the following description of exemplary embodiments with reference to the attached drawings.

ADVANTAGEOUS EFFECTS OF INVENTION

According to the present invention, for example, a cooling device advantageous in cooling a cooling target is provided.

Other features and advantages of the present invention will be apparent from the following description taken in conjunction with the accompanying drawings. Note that the same reference numerals denote the same or like components throughout the accompanying drawings.

BRIEF DESCRIPTION OF DRAWINGS

The accompanying drawings, which are incorporated in and constitute a part of the specification, illustrate embodiments of the invention and, together with the description, serve to explain principles of the invention.

Fig. 1 is a schematic circuit diagram showing the arrangement of a cooling device according to the first embodiment of the present invention;
Fig. 2 is a graph showing an example of a saturated vapor pressure curve of a refrigerant;
Fig. 3 is a graph showing a saturated vapor pressure curve of a low boiling point refrigerant and a saturated vapor pressure curve of a mixed refrigerant;
Fig. 4 is a schematic circuit diagram showing the arrangement of a cooling device according to the second embodiment of the present invention;
Fig. 5 is a schematic circuit diagram showing the arrangement of a cooling device according to the third embodiment of the present invention;
Fig. 6A is a schematic circuit diagram showing the arrangement of a cooling device according to the fourth embodiment of the present invention;
Fig. 6B is a schematic circuit diagram showing the arrangement of a cooling device according to the fourth embodiment of the present invention;
Fig. 6C is a schematic circuit diagram showing the arrangement of a cooling device according to the fourth embodiment of the present invention;
Fig. 7 is a schematic view showing the arrangement of an exposure apparatus;
Fig. 8 is a schematic view showing the arrangement of an imprint apparatus; and
Fig. 9 is a schematic view showing the arrangement of a plasma processing apparatus.

DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made an invention that requires all such features, and multiple such features may be combined as appropriate. Furthermore, in the attached drawings, the same reference numerals are given to the same or similar configurations, and redundant description thereof is omitted.

<First Embodiment>

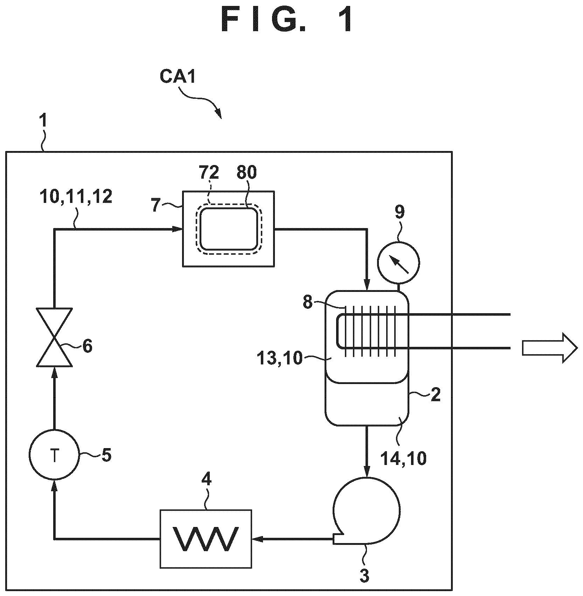

Fig. 1 is a schematic circuit diagram showing the arrangement of a cooling device CA1 according to the first embodiment of the present invention. A cooling target of the cooling device CA1 is not limited to a particular target and is, for example, a semiconductor manufacturing apparatus and especially the heat generating portion of the semiconductor manufacturing apparatus. The semiconductor manufacturing apparatus includes, for example, a pattern forming apparatus such as an exposure apparatus, an imprint apparatus, or an electron beam lithography apparatus, or a plasma processing apparatus such as a CVD apparatus, an etching apparatus, or a sputtering apparatus. The pattern forming apparatus includes a driving mechanism that drives a component such as a substrate and/or an original at high speed, and the driving mechanism generates heat along with driving of the component and thus becomes a heat generating portion. In the plasma processing apparatus, a component such as an electrode is heated by plasma and the component becomes a heat generating portion.

The cooling device CA1 is configured to cool a cooling target 80 such as a heat generating portion. As shown in Fig. 1, the cooling device CA1 includes a refrigerant circulation system 1 in which a condenser 2, a pump 3, a heater 4, a temperature sensor 5, a throttle valve 6, and a heat exchange container 7 are provided. The refrigerant circulation system 1 (cooling device CA1) forms a closed circulation system in which the cooling target 80 as a heat generating portion is stored in (inside) the heat exchange container 7. In this embodiment, the whole cooling target 80 is stored in the heat exchange container 7 but the present invention is not limited to this and at least a part of the cooling target 80 may be stored in the heat exchange container 7. A refrigerant 10 circulating through the refrigerant circulation system 1 is a mixed refrigerant obtained by mixing a low boiling point refrigerant 11 (a first refrigerant of a first boiling point) and a high boiling point refrigerant 12 (a second refrigerant of a second boiling point higher than the first boiling point), and more specifically, a non-azeotropic mixed refrigerant.

The refrigerant 10 (to be referred to as a "liquid refrigerant 14" hereinafter) in a liquid phase state stored in (inside) the condenser 2 is sent to the heater 4 by the pump 3. In this way, the pump 3 has a function of sending the liquid refrigerant 14 (mixed refrigerant) from the condenser 2. The heater 4 heats the liquid refrigerant 14 sent from the pump 3 so that the refrigerant temperature to be detected by the temperature sensor 5 arranged on the downstream side of the heater 4 becomes a predetermined management temperature. The heater 4 includes, for example, an electric heater or a heat exchanger for heating the liquid refrigerant 14 (controlling the temperature of the liquid refrigerant 14), but the present invention is not limited to this.

The pressure of the liquid refrigerant 14 that has been controlled to the management temperature is reduced by the throttle valve 6 to the extent that the low boiling point refrigerant 11 has a saturated vapor pressure at the management temperature, and the liquid refrigerant 14 is sent to the heat exchange container 7. In this way, the throttle valve 6 functions as a pressure reducer that reduces the pressure of the liquid refrigerant 14 sent from the pump 3 and supplies the liquid refrigerant 14 to the heat exchange container 7.

The heat exchange container 7 includes a heat exchange region 72 that exchanges heat with the cooling target 80, and incorporates the cooling target 80 in the heat exchange region 72. When the cooling target 80 incorporated in the heat exchange container 7 generates heat, the low boiling point refrigerant 11 of the liquid refrigerant 14 (mixed refrigerant) supplied to the heat exchange container 7 boils to cool the cooling target 80 by latent heat of vaporization, and the high boiling point refrigerant 12 convection-cools the cooling target 80. In this way, the low boiling point refrigerant 11 ebullient-cools the cooling target 80 in the heat exchange region 72 to enter a vapor phase state in the heat exchange container, and the high boiling point refrigerant 12 convection-cools the cooling target 80 in the liquid phase state in the heat exchange region 72 in the heat exchange container. The low boiling point refrigerant 11 that passes through the heat exchange region 72 in the heat exchange container and is discharged from the heat exchange container 7 is returned to the condenser 2 in the liquid phase state or a gas-liquid mixed phase (two-phase) state in accordance with the heat generation state of the cooling target 80. On the other hand, the high boiling point refrigerant 12 that passes through the heat exchange region 72 in the heat exchange container and is discharged from the heat exchange container 7 is always returned to the condenser 2 in the liquid phase state regardless of the heat generation state of the cooling target 80.

In this embodiment, the condenser 2 condenses the refrigerant 10 (mixed refrigerant) in the gas-liquid mixed phase state discharged from the heat exchange container 7 to obtain the liquid refrigerant 14. In the condenser 2, a heat exchanger 8 and a pressure sensor 9 are provided. The condenser 2 performs heat generation control to the outside of the refrigerant circulation system 1 via the heat exchanger 8 so that the pressure detected by the pressure sensor 9 always becomes a predetermined pressure.

By executing control so that the pressure of the low boiling point refrigerant 11 in the heat exchange container 7 becomes a saturated vapor pressure at the management temperature, the boiling point in the heat exchange container 7 is decided. In a case of ebullient cooling, since heat is recovered by latent heat of vaporization, large heat recovery is possible by a low refrigerant flow rate at a constant temperature.

When the low boiling point refrigerant 11 boils and evaporates, it becomes a refrigerant in the vapor phase state (to be referred to as a "gas refrigerant 13" hereinafter), floats due to a density difference from the high boiling point refrigerant 12, and occupies the upper space of the heat exchange container 7. However, in this embodiment, a predetermined amount of the high boiling point refrigerant 12 (liquid refrigerant 14) always exists in the heat exchange container, and the high boiling point refrigerant 12 passes through the cooling target 80 while being maintained in the liquid phase state. In other words, in this embodiment, the high boiling point refrigerant 12 in the liquid phase state exists from the upstream side to the downstream side of the cooling target 80. Thus, the exposure time of the cooling target 80 to the gas refrigerant 13 is reduced, thereby making it possible to suppress occurrence of a state in which the cooling target 80 (the upper part thereof) is covered with the gas refrigerant 13 and cannot be ebullient-cooled, that is, occurrence of dryout.

Furthermore, in a case where the cooling target 80 is a coil (coil line) of a linear motor, a groove portion between wires exists on the surface of the coil, and thus the high boiling point refrigerant 12 in the liquid phase state enters the groove portion on the coil surface due to a capillary phenomenon, and the low boiling point refrigerant 11 in the liquid phase state is also guided to the groove portion on the coil surface. This promotes ebullient cooling of the cooling target 80, thereby making it possible to suppress occurrence of dryout.

Note that if such refrigerant that the heat generation amount of the cooling target 80 is large and the vapor pressure at the management temperature is low is adopted as the low boiling point refrigerant 11, the upper part of the cooling target 80 is exposed to the gas refrigerant 13, and occurrence of dryout cannot be suppressed only by the cooling effect by the high boiling point refrigerant 12.

To suppress occurrence of dryout, a refrigerant having a high vapor pressure at the management temperature is adopted as the low boiling point refrigerant 11, and the gas refrigerant 13 that has lost the cooling capability is compressed by the pressure to reduce the occupied volume of the gas refrigerant 13, thereby making it easy to expose the cooling target 80 to the liquid refrigerant 14.

Note that in a case where the cooling target 80 is a linear motor having a jacket structure, it is necessary to move a coil in the jacket and a magnet outside the jacket close to each other to shorten the distance between the coil and the magnet in order to improve the thrust. Since the jacket has a thin structure that passes a magnetic force, the pressure resistance is in the order of 100 kPa. Since the vapor pressure of a refrigerant such as R32 adopted for a general refrigeration cycle is in the order of Mpa, such refrigerant cannot be adopted in a case where the cooling target 80 is a linear motor having a jacket structure. It is desirable to increase the vapor pressure of the refrigerant as much as possible within the pressure resistance range but it is very difficult to select such refrigerant.

To cope with this, in this embodiment, a non-azeotropic mixed refrigerant obtained by mixing the low boiling point refrigerant 11 and the high boiling point refrigerant 12 is adopted as a refrigerant for cooling the cooling target 80, and a physical phenomenon of raising the boiling point of the low boiling point refrigerant 11 is used.

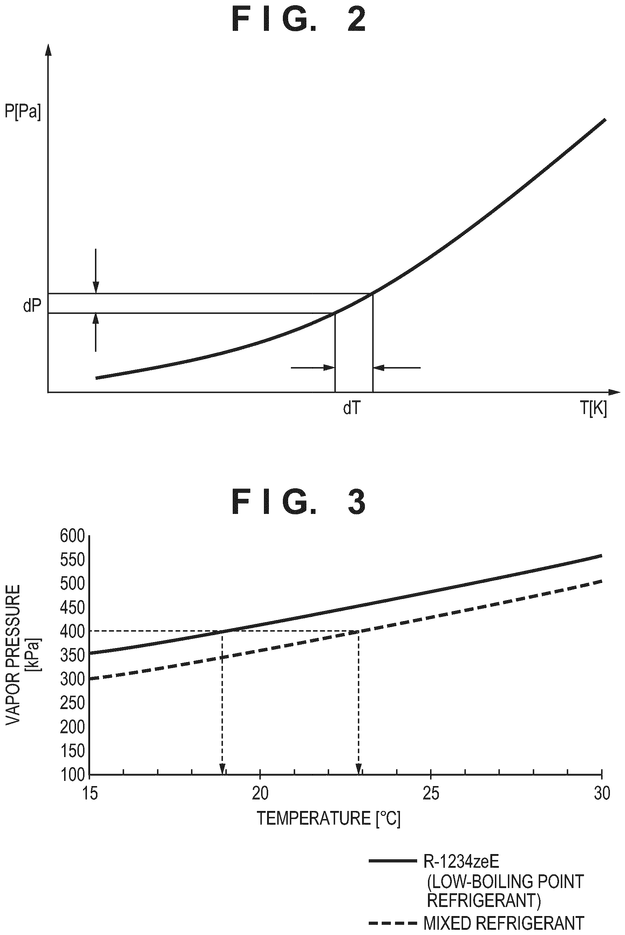

Fig. 2 is a graph showing an example of a saturated vapor pressure curve of a refrigerant. In Fig. 2, the abscissa represents a temperature T[K] and the ordinate represents a vapor pressure P [Pa]. The saturated vapor pressure curve of the refrigerant is decided by the physical property values of the refrigerant, is given by the following Clausius-Clapeyron equation, and is a right-upward curve, as shown in Fig. 2.

$$dP/dT = L/(Vv - Vl)/Ts$$

where dP represents a pressure change, dT represents a temperature change, L represents latent heat, Vv represents a vapor specific volume, Vl represents a liquid specific volume, and Ts represents a saturation temperature.

When mixing the high boiling point refrigerant 12 with the low boiling point refrigerant 11, if the high boiling point refrigerant 12 is simply a nonvolatile refrigerant, a boiling point rise (ΔT) can be given by:

$$\Delta T \approx xs \cdot R(T^*)^2/Lm$$

where ΔT represents the boiling point rise, R represents a gas constant, T* represents a low boiling point pure refrigerant boiling point, xs represents a high boiling point refrigerant molar fraction, and Lm represents low boiling point refrigerant molar latent heat of evaporation.

Referring to Fig. 2, the boiling point rise of the low boiling point refrigerant 11 is equivalent to translation of the saturated vapor pressure curve to a high-temperature side (rightward), and the vapor pressure of the low boiling point refrigerant 11 is lowered at the management temperature. Therefore, the vapor pressure can be adjusted by adjusting the mixing ratio between the low boiling point refrigerant 11 and the high boiling point refrigerant 12.

Consider, for example, a case where the management temperature is 23° and the pressure resistance of the heat exchange container 7 is 400 kPa abs. In addition, R-1234zeE (vapor pressure at 23°: 450 kPa) having a vapor pressure slightly higher than the pressure resistance of the heat exchange container 7 at the management temperature is adopted as the low boiling point refrigerant 11. Note that R-1234yf can also be adopted as the low boiling point refrigerant 11.

Fig. 3 is a graph showing a saturated vapor pressure curve of R-1234zeE as the low boiling point refrigerant 11 and a saturated vapor pressure curve of a mixed refrigerant having a vapor pressure equal to the pressure resistance (400 kPa) at the management temperature. In Fig. 3, the abscissa represents the temperature [°C] and the ordinate represents the vapor pressure [kPa]. Referring to Fig. 3, it is necessary to raise the boiling point by about 4°. It is understood that to raise the boiling point by 4°, it is only necessary to mix the high boiling point refrigerant 12 so that the molar fraction is about 0.2, by substituting the physical property values of R-1234zeE into the above-described equation of the boiling point rise (ΔT). At this time, it is preferable that the high boiling point refrigerant 12 has affinity with the low boiling point refrigerant 11 and the saturated vapor pressure is sufficiently low at the management temperature.

If the vapor pressure of the low boiling point refrigerant 11 is raised, it is possible to decrease the diameter of a bubble of the gas refrigerant 13 generated by ebullient cooling. When Pv represents a bubble internal pressure, Pl represents a liquid pressure, r represents a bubble diameter, and σ represents surface tension, the following equation holds due to balancing of the powers of the bubbles.

$$Pv = Pl + 2\sigma/r$$

From this equation, the bubble internal pressure is higher than the pressure of the surrounding liquid by a pressure of ΔP = 2σ/r.

In the interface of the bubble, the liquid is in an overheat state in which the temperature is higher than the saturation temperature. When Tl represents an overheat liquid temperature, Ps represents a saturated vapor pressure at the overheat liquid temperature, and Ts represent the saturation temperature at the liquid pressure Pl, the Clausius-Clapeyron equation is applied between the bubble and the liquid to obtain:

$$(Pv - Pl)/(Tl - Ts) = L/(Vv - Vl)/Ts$$

This equation is approximated by setting Vv >> Vl and Pv ≈ Ps to obtain:

$$\Delta P = Pv - Pl \approx L(Tl - Ts)/Vv/Ts$$

When Vv is inversely proportional to Pl according to the Boyle's law to allow the physical property of R-1234ZeE and several degrees of overheat, a pressure difference of about 100 kPa can be caused, and the bubble can be compressed to about 1/5 with respect to the atmospheric pressure along with the rise in vapor pressure.

If the refrigerant having large latent heat of vaporization is adopted as the low boiling point refrigerant 11, the vapor volume is reduced and the amount of the gas refrigerant 13 can be reduced. The latent heat of R-1234ZeE is 195.4 J/g. Since R-1234ZeE is a refrigerant having relatively large latent heat, it is a refrigerant suitable for a countermeasure against dryout, and has a global warming potential (GWP) of 6 and is thus environmentally superior.

As described above, in this embodiment, in the refrigerant circulation system 1, a mixed refrigerant is circulated so that the entire heat exchange region 72 of the heat exchange container 7 is exposed to the mixed refrigerant including the low boiling point refrigerant 11 and the high boiling point refrigerant 12 both of which are in the liquid phase state and the mixed refrigerant in the gas-liquid mixed phase is discharged from the heat exchange container 7. To achieve this, the mixed refrigerant is mixed at such mixing ratio that in the heat exchange container, the low boiling point refrigerant 11 ebullient-cools the cooling target 80 to enter the vapor phase state and the high boiling point refrigerant 12 convection-cools the cooling target 80 in the liquid phase state and compresses the low boiling point refrigerant 11 in the vapor phase state.

More specifically, a non-azeotropic mixed refrigerant is adopted as a mixed refrigerant, and the mixing ratio between the low boiling point refrigerant 11 and the high boiling point refrigerant 12 is adjusted, thereby increasing the vapor pressure of the low boiling point refrigerant 11 to a high pressure close to the pressure resistance of the heat exchange container 7. This can compress the low boiling point refrigerant in the vapor phase state, which has been generated by ebullient cooling. Furthermore, the bubble diameter of the low boiling point refrigerant in the vapor phase state is decreased, and the bubble internal pressure rises by the curvature ratio of the bubble, as compared with the surrounding liquid. This can further compress the low boiling point refrigerant in the vapor phase state, which has been generated by ebullient cooling. This compression effect decreases the occupied volume ratio, in the heat exchange container, of the low boiling point refrigerant in the liquid phase state, which has lost the cooling capability, thereby making it possible to suppress occurrence of dryout.

<Second Embodiment>

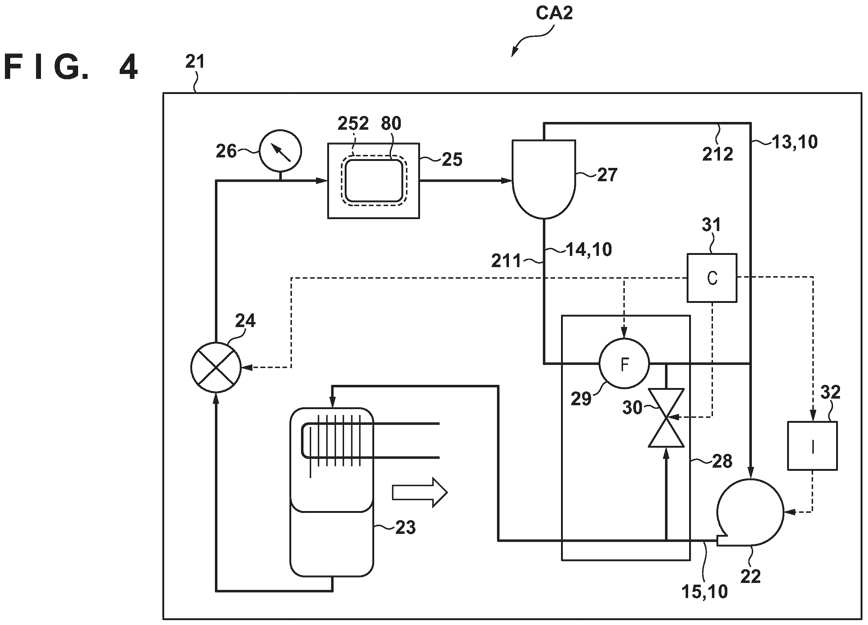

Fig. 4 is a schematic circuit diagram showing the arrangement of a cooling device CA2 according to the second embodiment of the present invention. The cooling device CA2 according to this embodiment is obtained by applying the cooling device CA1 (circulation of a liquid refrigerant by a pump) of the first embodiment to a general refrigeration cycle of circulating a gas refrigerant by a compressor. Note that matters not mentioned in this embodiment are the same as in the first embodiment.

The cooling device CA2 is configured to cool a cooling target 80 such as a heat generating portion. As shown in Fig. 4, the cooling device CA2 includes a refrigerant circulation system 21 in which a compressor 22, a condenser 23, an expansion valve 24, and a heat exchange container 25 are provided. The refrigerant circulation system 21 (cooling device CA2) forms a closed circulation system in which the cooling target 80 as a heat generating portion is stored in (inside) the heat exchange container 25. In this embodiment, the whole cooling target 80 is stored in the heat exchange container 25 but the present invention is not limited to this and at least a part of the cooling target 80 may be stored in the heat exchange container 25. Similar to the first embodiment, a refrigerant 10 circulating through the refrigerant circulation system 21 is a mixed refrigerant obtained by mixing a low boiling point refrigerant 11 (a first refrigerant of a first boiling point) and a high boiling point refrigerant 12 (a second refrigerant of a second boiling point higher than the first boiling point), and more specifically, a non-azeotropic mixed refrigerant. Note that unlike the first embodiment, the high boiling point refrigerant 12 is in the vapor phase state when it is sent to the compressor 22.

The compressor 22 compresses a refrigerant (gas refrigerant 13) in the vapor phase state and sends it to the condenser 23. The condenser 23 condenses the gas refrigerant 13 by exhausting heat of the gas refrigerant 13 sent from the compressor 22 using a cooling medium (not shown) such as cooling water, thereby obtaining the refrigerant (liquid refrigerant 14) in the liquid phase state. The pressure of the liquid refrigerant 14 from the condenser 23 is reduced to a pressure around the saturated vapor pressure by the expansion valve 24, and the liquid refrigerant 14 is sent to the heat exchange container 25. In this way, the expansion valve 24 functions as a pressure reducer that reduces the pressure of the liquid refrigerant 14 from the condenser 23 and supplies the liquid refrigerant 14 to the heat exchange container 25.

The heat exchange container 25 includes a heat exchange region 252 that exchanges heat with the cooling target 80, and incorporates the cooling target 80 in the heat exchange region 252. When the cooling target 80 incorporated in the heat exchange container 25 generates heat, the low boiling point refrigerant 11 of the liquid refrigerant 14 (mixed refrigerant) supplied to the heat exchange container 25 boils to cool the cooling target 80 by latent heat of vaporization, and the high boiling point refrigerant 12 convection-cools the cooling target 80. In this way, the low boiling point refrigerant 11 ebullient-cools the cooling target 80 to enter the vapor phase state in the heat exchange region 252 in the heat exchange container, and the high boiling point refrigerant 12 convection-cools the cooling target 80 in the liquid phase state in the heat exchange region 252 in the heat exchange container. The low boiling point refrigerant 11 that passes through the heat exchange region 252 in the heat exchange container and is discharged from the heat exchange container 25 enters the liquid phase state or the gas-liquid mixed phase (two-phase) state in accordance with the heat generation state of the cooling target 80. On the other hand, the high boiling point refrigerant 12 that passes through the heat exchange region 252 in the heat exchange container and is discharged from the heat exchange container 25 is always maintained in the liquid phase state regardless of the heat generation state of the cooling target 80. Note that a pressure sensor 26 is provided on the downstream side of the expansion valve 24, and an opening of the expansion valve 24 is controlled so that the pressure of the heat exchange container 25 (the pressure detected by the pressure sensor 26) is always close to the vapor pressure of the low boiling point refrigerant 11.

The refrigerant discharged from the heat exchange container 25 always includes the liquid refrigerant 14. Therefore, if the refrigerant discharged from the heat exchange container 25 is directly returned to the compressor 22, the compressor 22 cannot compress the refrigerant in the liquid phase state, and is thus damaged.

To cope with this, in this embodiment, a gas-liquid separation portion 27 that separates the refrigerant (mixed refrigerant) in the gas-liquid mixed phase state discharged from the heat exchange container 25 into the gas refrigerant 13 (the refrigerant in the vapor phase state) and the liquid refrigerant 14 (the refrigerant in the liquid phase state) is provided between the heat exchange container 25 and the compressor 22. The refrigerant circulation system 21 includes a first path 211 for returning, to the compressor 22, the liquid refrigerant 14 separated by the gas-liquid separation portion 27 and a second path 212 for returning, to the compressor 22, the gas refrigerant 13 separated by the gas-liquid separation portion 27. The first path 211 is connected to the compressor 22 via a first vaporizer 28 that vaporizes the liquid refrigerant 14 separated by the gas-liquid separation portion 27 to obtain the refrigerant in the vapor phase state. On the other hand, the second path 212 is directly connected to the compressor 22.

As described above, in this embodiment, the gas refrigerant 13 separated by the gas-liquid separation portion 27 is directly returned to the compressor 22 through the second path 212, and the liquid refrigerant 14 separated by the gas-liquid separation portion 27 is sent to the first vaporizer 28 before being returned to the compressor 22. The first vaporizer 28 causes a high-temperature gas refrigerant 15 on the downstream side of the compressor 22 to branch before returning it to the condenser 23 and merge with the liquid refrigerant 14 separated by the gas-liquid separation portion 27, and vaporizes the liquid refrigerant 14 by the high-temperature gas refrigerant 15 to return to the compressor 22.

The first vaporizer 28 includes a flow rate sensor 29 that detects the flow rate of the liquid refrigerant 14, a throttle valve 30 that adjusts the flow rate of the high-temperature gas refrigerant 15, and a flow rate controller 31. The flow rate controller 31 controls the throttle valve 30 based on the flow rate of the liquid refrigerant 14 detected by the flow rate sensor 29 so that the flow rate of the high-temperature gas refrigerant 15 made to merge with the liquid refrigerant 14 becomes a flow rate necessary to vaporize the liquid refrigerant 14. In this way, the first vaporizer 28 vaporizes the liquid refrigerant 14 by making a part of the gas refrigerant 15 (the mixed refrigerant in the vapor phase state) sent from the compressor 22 merge, via the throttle valve 30, with the liquid refrigerant 14 separated by the gas-liquid separation portion 27. Note that an ultrasonic sensor is suitable as the flow rate sensor 29 but the present invention is not limited to this.

An increase in flow rate of the liquid refrigerant 14 included in the refrigerant discharged from the heat exchange container 25 indicates a decrease in heat generation amount of the cooling target 80 incorporated in the heat exchange container 25, thereby making it possible to decrease the flow rate of the liquid refrigerant 14 to be supplied to the heat exchange container 25. The flow rate controller 31 controls the opening of the throttle valve 30 while controlling (throttling) the opening of the expansion valve 24, thereby properly controlling the flow rate balance between the liquid refrigerant 14 separated by the gas-liquid separation portion 27 and the high-temperature gas refrigerant 15 from the compressor 22. Furthermore, the flow rate controller 31 may control the compression capability (the total flow rate of the refrigerant) of the compressor 22 via an inverter 32. This can prevent the liquid refrigerant 14 from returning to the compressor 22, and maintain the refrigeration cycle following the variation of a heat load.

As described above, according to this embodiment, it is possible to implement the cooling device CA2 applied to the general refrigeration cycle. In the cooling device CA1 according to the first embodiment, in a case where the heat exchange container 7 recovers a large heat amount and the condenser 2 exhausts heat, two circulation systems via different refrigeration cycles are necessary. On the other hand, in the cooling device CA2 according to this embodiment, it is possible to exhaust heat by one circulation system. Therefore, it is possible to provide the cooling device CA2 that contributes to space saving and energy saving.

<Third Embodiment>

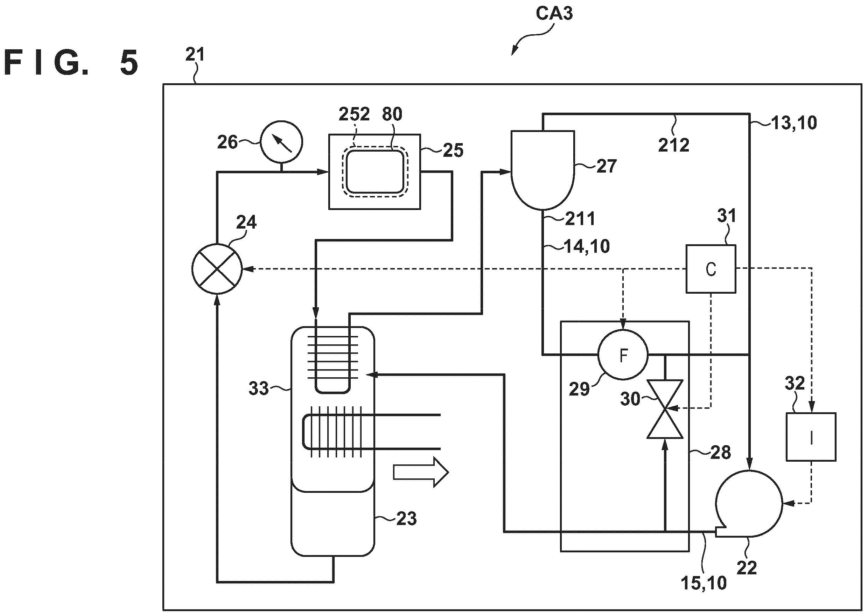

Fig. 5 is a schematic circuit diagram showing the arrangement of a cooling device CA3 according to the third embodiment of the present invention. The cooling device CA3 according to this embodiment is obtained by improving the cooling device CA2 of the second embodiment. Note that matters not mentioned in this embodiment are the same as in the second embodiment.

In this embodiment, a second vaporizer 33 that vaporizes a refrigerant (mixed refrigerant) in the gas-liquid mixed phase state discharged from a heat exchange container 25 is newly provided between the heat exchange container 25 and a gas-liquid separation portion 27. The second vaporizer 33 is implemented as, for example, a heat exchanger that is provided in a condenser 23 and exchanges heat between a high-temperature gas refrigerant 15 (a mixed refrigerant in the vapor phase state) sent from a compressor 22 and a refrigerant (mixed refrigerant) in the gas-liquid mixed phase state discharged from the heat exchange container 25. A liquid refrigerant 14 included in the refrigerant discharged from the heat exchange container 25 is heated by the high-temperature gas refrigerant 15 in the second vaporizer 33, and partially vaporizes. On the other hand, the high-temperature gas refrigerant 15 is cooled by latent heat of vaporization of the liquid refrigerant 14, and partially condenses.

According to this embodiment, since the condenser 23 partially condenses the high-temperature gas refrigerant 15 sent from the compressor 22 by the liquid refrigerant 14 discharged from the heat exchange container 25, it is possible to reduce the exhaust heat amount outside the system. In addition, by providing two vaporizers of the first vaporizer 28 and the second vaporizer 33, it is possible to further reduce the risk of damage of the compressor 22 caused by mixing of the liquid refrigerant 14.

<Fourth Embodiment>

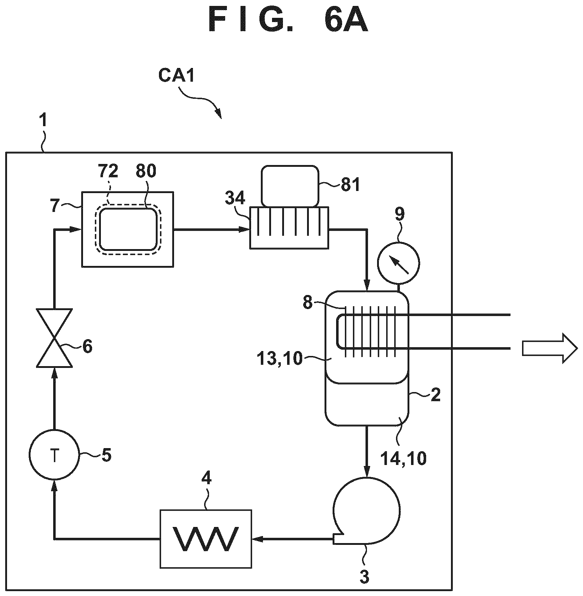

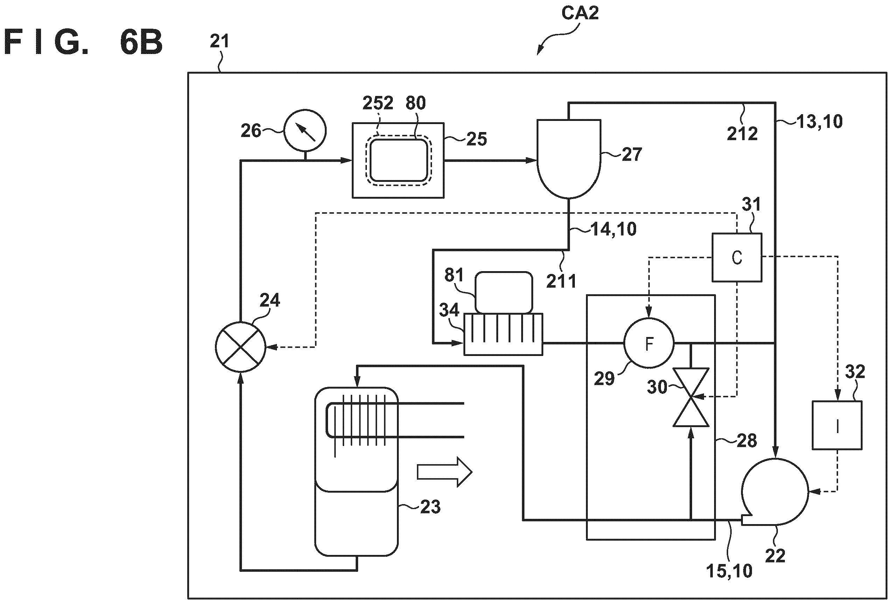

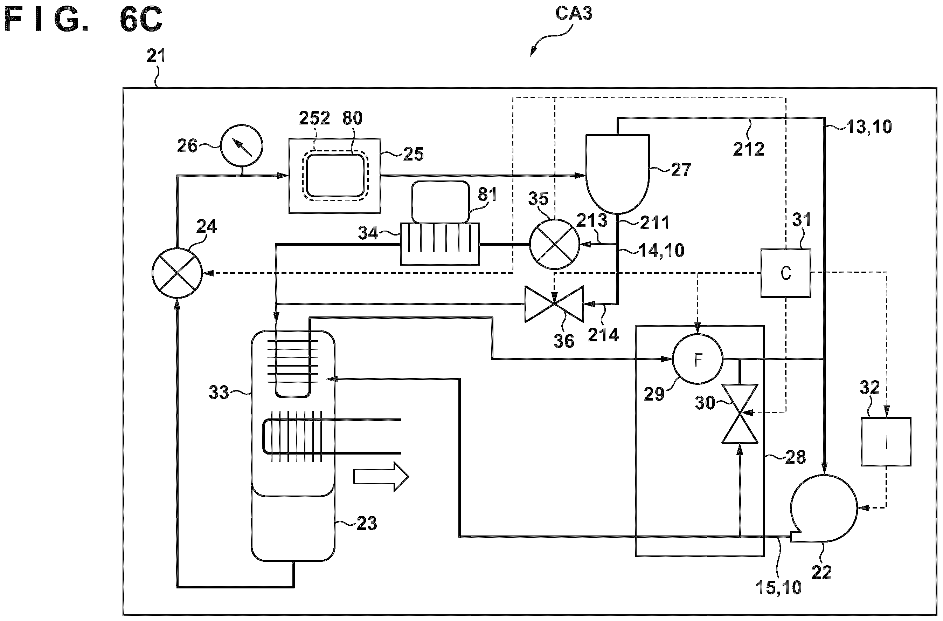

Figs. 6A, 6B, and 6C are schematic circuit diagrams each showing the arrangement of a cooling device according to the fourth embodiment of the present invention. Each of the first to third embodiments is limited to cooling of the cooling target 80 incorporated in the heat exchange container 7 or 25. However, in a large-scale system such as an exposure apparatus, many cooling targets (heating elements) exist in addition to the cooling target 80. A refrigerant that does not vaporize in the heat exchange container 7 or 25 or the liquid refrigerant 14 separated by the gas-liquid separation portion 27 is in the liquid phase state, and thus has a capability of ebullient-cooling the cooling target. In this embodiment, a new path for cooling another cooling target (a cooling target different from a cooling target 80) not incorporated in a heat exchange container 7 or 25 is formed.

Fig. 6A shows a case where a path for cooling a cooling target 81 different from the cooling target 80 is formed in the cooling device CA1 of the first embodiment. The cooling device CA1 includes a heat exchanger 34 on the downstream side of the heat exchange container 7. The heat exchanger 34 thermally contacts the cooling target 81, and exchanges heat between the cooling target 81 and a refrigerant (mixed refrigerant) in the gas-liquid mixed phase state discharged from the heat exchange container 7, thereby cooling the cooling target 81. In the heat exchanger 34, a liquid refrigerant 14 that does not vaporize in the heat exchange container 7 boils by taking heat from the cooling target 81, thereby ebullient-cooling the cooling target 81. Note that the refrigerant having passed through the heat exchanger 34 is returned in the gas-liquid mixed phase state to the condenser 2, is cooled by the condenser 2 to change in phase, and is then recirculated as the liquid refrigerant 14.

Fig. 6B shows a case where a path for cooling the cooling target 81 different from the cooling target 80 is formed in the cooling device CA2 of the second embodiment. The cooling device CA2 includes the heat exchanger 34 in a first path 211 through which the liquid refrigerant 14 separated by a gas-liquid separation portion 27 on the downstream side of the heat exchange container 25 flows. The heat exchanger 34 thermally contacts the cooling target 81, and exchanges heat between the cooling target 81 and the liquid refrigerant 14 separated by the gas-liquid separation portion 27, thereby cooling the cooling target 81. In the heat exchanger 34, the liquid refrigerant 14 separated by the gas-liquid separation portion 27 boils by taking heat from the cooling target 81, thereby ebullient-cooling the cooling target 81. Note that the refrigerant having passed through the heat exchanger 34 is sent in the vapor phase state or the gas-liquid mixed phase state to a first vaporizer 28, completely vaporizes in the first vaporizer 28, and is returned as a gas refrigerant 13 to a compressor 22 to be recirculated.

Fig. 6C shows a case where a path for cooling the cooling target 81 different from the cooling target 80 is formed in the cooling device CA3 of the third embodiment. In the cooling device CA3, the first path 211 through which the liquid refrigerant 14 separated by the gas-liquid separation portion 27 flows branches into a third path 213 and a fourth path 214. The third path 213 is a path to a second vaporizer 33 via an expansion valve 35 and the heat exchanger 34, and the fourth path 214 is a path to the second vaporizer 33 via a throttle valve 36. In this system, the pressure of the liquid refrigerant 14 is adjusted to a predetermined vapor pressure via the expansion valve 35. This is equivalent to adjustment of the boiling point of the liquid refrigerant 14, and it is thus possible to cool the cooling target 81 at a predetermined temperature. Therefore, this is particularly preferable in a case where the cooling target 81 requires temperature management. Note that the same arrangement can be applied to the cooling device CA1 of the first embodiment or the cooling device CA2 of the second embodiment.

According to this embodiment, it is possible to ebullient-cool the cooling target 81 different from the cooling target 80 incorporated in the heat exchange container 7 or 25 using the high boiling point refrigerant 12. Therefore, similar to the general refrigeration cycle, the cooling device according to this embodiment can efficiently cools the whole large system such as an exposure apparatus by one refrigerant circulation system.

<Fifth Embodiment>

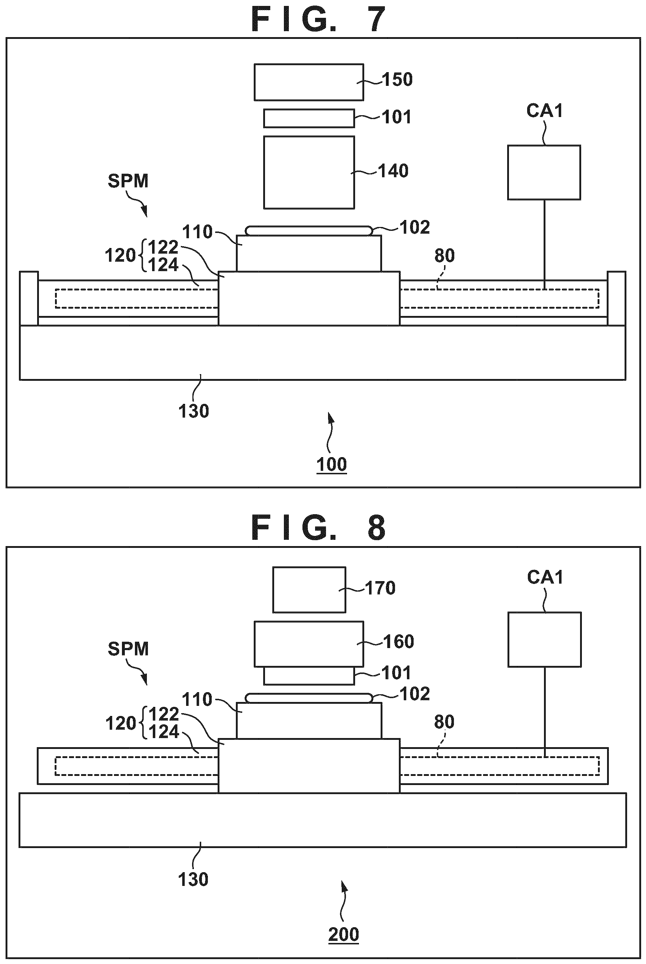

A semiconductor manufacturing apparatus to which a cooling device CA1, CA2, or CA3 is applicable, and in this embodiment, a semiconductor manufacturing apparatus to which the cooling device CA1 is applied will exemplarily be described below with reference to Figs. 7, 8, and 9.

Fig. 7 is a schematic view showing the arrangement of a semiconductor manufacturing apparatus, and more specifically, the arrangement of an exposure apparatus 100 as an example of a pattern forming apparatus. The exposure apparatus 100 is configured to transfer a pattern of an original 101 through a projection optical system 140 to a photosensitive layer supplied (applied) to a substrate 102. The exposure apparatus 100 includes an illumination optical system 150 that illuminates the original 101, the projection optical system 140, a substrate positioning mechanism SPM that positions the substrate 102, and an original positioning mechanism (not shown) that positions the original 101.

The substrate positioning mechanism SPM includes a substrate stage 110 that supports a substrate chuck holding the substrate 102, a driving mechanism 120 that drives the substrate stage 110, and a base member 130 that supports the driving mechanism 120. The driving mechanism 120 includes an actuator including a mover 122 that moves together with the substrate stage 110 and a stator 124 fixed to the base member 130. The stator 124 includes a coil (coil line) as the cooling target 80 of the cooling device CA1. The cooling device CA1 is configured to cool the coil of the stator 124 serving as the cooling target 80.

Fig. 8 is a schematic view showing the arrangement of a semiconductor manufacturing apparatus, and more specifically, the arrangement of an imprint apparatus 200 as an example of a pattern forming apparatus. The imprint apparatus 200 is configured to transfer the pattern of the original 101 (mold) to an imprint material arranged on (supplied to) the substrate 102. The imprint apparatus 200 includes an original driving mechanism 160 that drives the original 101, the substrate positioning mechanism SPM that drives the substrate 102, and a curing unit 170 that cures the imprint material arranged on the substrate 102.

At least one of the original driving mechanism 160 and the substrate positioning mechanism SPM can align a pattern region of the original 101 and a shot region of the substrate 102. At least one of the original driving mechanism 160 and the substrate positioning mechanism SPM can bring the pattern region of the original 101 and the imprint material arranged on the substrate 102 into contact with each other, and separate the pattern region of the original 101 and the imprint material arranged on the substrate 102.

While the imprint material arranged on the substrate 102 and the pattern region of the original 101 are in contact with each other, the imprint apparatus 200 causes the curing unit 170 to cure the imprint material, and separates the cured imprint material and the original 101. This forms a pattern made of the cured product of the imprint material on the substrate 102. In other words, the pattern of the original 101 is transferred to the imprint material arranged on the substrate 102.

As described above, the substrate positioning mechanism SPM includes the substrate stage 110 that supports the substrate chuck holding the substrate 102, the driving mechanism 120 that drives the substrate stage 110, and the base member 130 that supports the driving mechanism 120. The driving mechanism 120 includes an actuator including the mover 122 that moves together with the substrate stage 110 and the stator 124 fixed to the base member 130. The stator 124 includes a coil (coil line) as the cooling target 80 of the cooling device CA1. The cooling device CA1 is configured to cool the coil of the stator 124 serving as the cooling target 80.

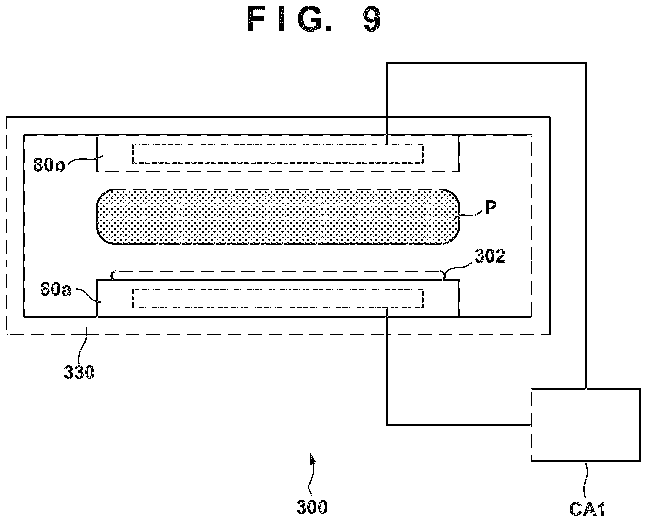

Fig. 9 is a schematic view showing the arrangement of a plasma processing apparatus 300 as an example of a semiconductor manufacturing apparatus. The plasma processing apparatus 300 includes, for example, a CVD apparatus, an etching apparatus, or a sputtering apparatus. The plasma processing apparatus 300 includes a chamber 330, and an electrode structure serving as one or a plurality of cooling targets 80a and 80b arranged in the chamber 330.

In this embodiment, a substrate 302 is supported by the cooling target 80a. A gas for generating plasma is supplied into the chamber 330. When the plasma processing apparatus 300 is constituted as a CVD apparatus, a deposition gas is supplied into the chamber 330. When the plasma processing apparatus 300 is constituted as an etching apparatus, an etching gas is supplied into the chamber 330. When the plasma processing apparatus 300 is constituted as a sputtering apparatus, a gas for generating plasma is supplied into the chamber 330, and a target is attached to the electrode structure serving as the cooling target 80b. The cooling device CA1 is configured to cool the cooling targets 80a and 80b.

<Sixth Embodiment>

A semiconductor manufacturing method as one aspect of the present invention includes a step of processing a substrate by a semiconductor manufacturing apparatus represented by the above-described exposure apparatus 100, imprint apparatus 200, and plasma processing apparatus 300, and a step of treating the substrate processed in the step. The step of processing the substrate by the semiconductor manufacturing apparatus includes, for example, a step of forming a pattern on the substrate, a step of forming a film on the substrate, or a step of etching the substrate or the film formed on it. The step of treating the substrate includes, for example, a step of dividing (dicing) the substrate or a step of sealing the substrate. The semiconductor manufacturing method according to this embodiment is advantageous in at least one of the performance, quality, productivity, and production cost of the semiconductor, as compared to conventional methods.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2022-095225 filed June 13, 2022, which is hereby incorporated by reference herein.

**Claims**

1. A cooling device for cooling a cooling target, **characterized by** comprising:

   a circulation system configured to circulate a refrigerant for cooling the cooling target, wherein a container including a region where heat is exchanged between the refrigerant and at least a part of the cooling target is provided in the circulation system, the refrigerant is a mixed refrigerant obtained by mixing a first refrigerant of a first boiling point and a second refrigerant of a second boiling point higher than the first boiling point, the circulation system circulates the mixed refrigerant so that the mixed refrigerant enters the container at a predetermined temperature, and the first refrigerant has a vapor pressure higher than a pressure resistance of the container at the predetermined temperature.

2. The cooling device according to claim 1, **characterized in that** the circulation system circulates the mixed refrigerant so that the region is exposed to the mixed refrigerant having entered the container while the first refrigerant and the second refrigerant are in a liquid phase state, and the mixed refrigerant including the first refrigerant, a part of which is in a vapor phase state, and the second refrigerant in the liquid phase state is discharged from the container.

3. The cooling device according to claim 1, **characterized in that** the first refrigerant and the second refrigerant are mixed at such mixing ratio that the first refrigerant ebullient-cools the cooling target to enter a vapor phase state in the region, and the second refrigerant convection-cools the cooling target in a liquid phase state and compresses the first refrigerant in the vapor phase state in the region.

4. The cooling device according to claim 1, **characterized in that** the mixed refrigerant is a non-azeotropic mixed refrigerant.

5. The cooling device according to claim 1, **characterized in that**

   a compressor configured to compress a mixed refrigerant in a vapor phase state and send the mixed refrigerant, a condenser configured to condense the mixed refrigerant in the vapor phase state sent from the compressor to obtain a mixed refrigerant in a liquid phase state, a pressure reducer configured to reduce a pressure of the mixed refrigerant in the liquid phase state from the condenser and supply the mixed refrigerant to the container, and a gas-liquid separation portion configured to separate the mixed refrigerant in a gas-liquid mixed phase state discharged from the container into a refrigerant in the vapor phase state and a refrigerant in the liquid phase state are provided in the circulation system, the circulation system includes a first path for returning, to the compressor, the refrigerant in the liquid phase state separated by the gas-liquid separation portion and a second path for returning, to the compressor, the refrigerant in the vapor phase state separated by the gas-liquid separation portion, the first path is connected to the compressor via a first vaporizer configured to vaporize the refrigerant in the liquid phase state separated by the gas-liquid separation portion to obtain a refrigerant in the vapor phase state, and the second path is directly connected to the compressor.

6. The cooling device according to claim 5, **characterized in that** the first vaporizer vaporizes the refrigerant in the liquid phase state by making a part of the mixed refrigerant in the vapor phase state sent from the compressor merge, via a throttle valve, with the refrigerant in the liquid phase state separated by the gas-liquid separation portion.

7. The cooling device according to claim 5, **characterized by** further comprising a second vaporizer provided between the container and the gas-liquid separation portion and configured to vaporize the mixed refrigerant in the gas-liquid mixed phase state discharged from the container.

8. The cooling device according to claim 7, **characterized in that** the second vaporizer includes a heat exchanger provided in the condenser and configured to exchange heat between the mixed refrigerant in the vapor phase state sent from the compressor and the mixed refrigerant in the gas-liquid mixed phase state discharged from the container.

9. The cooling device according to claim 5, **characterized by** further comprising a heat exchanger configured to cool a cooling target different from the cooling target by exchanging heat between the different cooling target and the refrigerant in the liquid phase state separated by the gas-liquid separation portion.

10. The cooling device according to claim 1, **characterized in that** a heater configured to heat the mixed refrigerant so that a temperature of the mixed refrigerant becomes the predetermined temperature is provided in the circulation system.

11. The cooling device according to claim 1, **characterized in that** a condenser configured to condense a mixed refrigerant in a gas-liquid mixed phase state discharged from the container to obtain a mixed refrigerant in a liquid phase state, a pump configured to send the mixed refrigerant in the liquid phase state from the condenser, and a pressure reducer configured to reduce a pressure of the mixed refrigerant in the liquid phase state sent from the pump and supply the mixed refrigerant to the container are provided in the circulation system.

12. The cooling device according to claim 11, **characterized by** further comprising a heat exchanger configured to cool a cooling target different from the cooling target by exchanging heat between the different cooling target and the mixed refrigerant in the gas-liquid mixed phase state discharged from the container.

13. The cooling device according to claim 1, **characterized in that** the first refrigerant is one of R1234zeE and R-1234yf.

14. A semiconductor manufacturing apparatus that includes a heat generating portion, **characterized by** comprising:

    a cooling device defined in claim 1,
    wherein the cooling device is configured to cool the heat generating portion as a cooling target.

15. The semiconductor manufacturing apparatus according to claim 14, **characterized in that** the semiconductor manufacturing apparatus is formed as a pattern forming apparatus configured to form a pattern.

16. A semiconductor manufacturing method **characterized by** comprising:

    a step of processing a substrate by a semiconductor manufacturing apparatus defined in claim 14; and
    a step of treating the substrate processed in the step.

# F I G. 1

CA1

# F I G. 2

# F I G. 3

FIG. 4

CA2

F I G. 5

EP 4 484 875 A1

# F I G.   6A

FIG. 6B

# F I G. 6C

EP 4 484 875 A1

# F I G. 7

# F I G. 8

# F I G. 9

80b

P

302

80a

330

300

CA1

## INTERNATIONAL SEARCH REPORT

International application No.

**PCT/JP2023/013209**

### A. CLASSIFICATION OF SUBJECT MATTER

***F28D 15/02***(2006.01)i; ***F25B 1/00***(2006.01)i; ***F25B 5/04***(2006.01)i; ***G03F 7/20***(2006.01)i; ***H05K 7/20***(2006.01)i
FI: F28D15/02 104B; F25B1/00 311B; F25B1/00 396B; F25B5/04 Z; F28D15/02 L; F28D15/02 101L; G03F7/20 521; H05K7/20 Q

According to International Patent Classification (IPC) or to both national classification and IPC

### B. FIELDS SEARCHED

Minimum documentation searched (classification system followed by classification symbols)
F28D15/00-15/06; F25B1/00; F25B5/04; G03F7/20; H05K7/20; H01L23/427

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2022-20088 A (CANON INC.) 01 February 2022 (2022-02-01) particularly, paragraphs [0013]-[0016], fig. 1 | 1-4, 10-16 |
| A | | 5-9 |
| Y | JP 2004-232951 A (MITSUBISHI ELECTRIC CORP.) 19 August 2004 (2004-08-19) particularly, paragraphs [0023]-[0024], [0036]-[0037] | 1-4, 10-16 |
| A | | 5-9 |
| Y | JP 2007-163086 A (SHOWA DENKO KK) 28 June 2007 (2007-06-28) particularly, paragraph [0005] | 1-4, 10-16 |
| A | | 5-9 |
| A | JP 6-60306 B2 (SANYO ELECTRIC CO., LTD.) 10 August 1994 (1994-08-10) particularly, column 4, lines 14-42, fig. 1 | 1-16 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **26 May 2023** | **06 June 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (January 2015)

INTERNATIONAL SEARCH REPORT
Information on patent family members

International application No.

**PCT/JP2023/013209**

| Patent document cited in search report | | | Publication date (day/month/year) | Patent family member(s) | | | Publication date (day/month/year) |
|---|---|---|---|---|---|---|---|
| JP | 2022-20088 | A | 01 February 2022 | US | 2021/0404711 | A1 | |
| | | | | particularly, paragraphs [0021]-[0024], fig. 1 | | | |
| | | | | EP | 3933298 | A1 | |
| | | | | CN | 113847759 | A | |
| | | | | TW | 202205375 | A | |
| | | | | KR | 10-2022-0001461 | A | |
| JP | 2004-232951 | A | 19 August 2004 | (Family: none) | | | |
| JP | 2007-163086 | A | 28 June 2007 | (Family: none) | | | |
| JP | 6-60306 | B2 | 10 August 1994 | US | 5062985 | A | |
| | | | | particularly, column 4, lines 19-41, fig. 1 | | | |
| | | | | EP | 402937 | A1 | |
| | | | | BR | 9002854 | A | |
| | | | | AU | 5713290 | A | |
| | | | | CA | 2019096 | A1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5313384 B

- JP 2022095225 A